Europäisches Patentamt

European Patent Office

Office européen des brevets

(19)

(11) Publication number: **0 199 450**
A2

# (12) EUROPEAN PATENT APPLICATION

(21) Application number: **86301851.1**

(22) Date of filing: **14.03.86**

(51) Int. Cl.⁴: **H 05 K 3/38**

(30) Priority: **16.03.85 GB 8506895**

(43) Date of publication of application:
**29.10.86 Bulletin 86/44**

(84) Designated Contracting States:
**AT BE CH DE FR IT LI LU NL SE**

(71) Applicant: **MARCONI ELECTRONIC DEVICES LIMITED**
**The Grove Warren Lane**
**Stanmore Middlesex HA7 4LY(GB)**

(72) Inventor: **Pilcher, Heather**
**Schumack Hankerton Road Upper Minety**
**Nr. Swindon Wiltsire(GB)**

(74) Representative: **Hoste, Colin Francis**
**The General Electric Company p.l.c. Central Patent**
**Department (Chelmsford Office) Marconi Research**
**Centre West Hanningfield Road**
**Great Baddow Chelmsford CM2 8HN, Essex(GB)**

(54) **Printed electrical circuit.**

(57) An electrical circuit consists of a moulded substrate consisting of a thermosetting plastics material having a specially roughened surface. Low-temperature curing polymer ink is screen printed on to the roughened surface, to which it adheres with a strong bond.

FIG. I.

EP 0 199 450 A2

0199450

I/7031/MEDL

ELECTRICAL CIRCUIT

This invention relates to an electrical circuit of the kind which is formed upon an insulating substrate by the selective application of a suitable settable electrical fluid. Such a circuit is sometimes called a hybrid circuit. The fluid is generally termed an ink and is chosen with regard to its electrical properties; it may be an electrically conductive ink, although resistive and dielectric inks are also used, depending on the circuit property required. In the process, the ink is applied to the surface of the substrate through a suitably shaped screen consisting of open portions in the form of a fine mesh. Subsequent to the application of the ink in a fluid state, it is cured at an elevated temperature in order to set it.

Invariably, the substrate has been formed of a ceramic material and the inks have been of the cermet kind which are fired at very high temperatures, typically at about $850^{o}$C, and it is this very high firing temperature which has necessitated the use of special ceramics. Inks which cure at much lower temperatures are becoming available and they have been used for certain applications, but they have been shown to exhibit very severe disadvantages. The present invention seeks to provide an improved electrical circuit which is formed by the application of an electrical ink.

According to a first aspect of this invention, an electrical circuit includes a substrate of an electrical insulating material having a roughened surface region; said region carrying a low-temperature cured electrical ink of the kind which cures at a temperature of less than $200^{o}C$, the degree of roughness being such as to produce strong adhesion between the substrate and the cured ink.

According to a second aspect of this invention, an electrical circuit includes a substrate formed of an electrically insulating thermo-setting plastics material having a roughened surface region; said region carrying a low-temperature cured conductive polymer ink, the degree of roughness being such as to produce strong bonding resisting separation of the cured ink from the substrate.

The adhesion and bonding is in contrast to the effect which is obtained when a polymer ink is laid down on to a conventional smooth, usually shiny, surface. Although the ink, when cured, remains in place on the smooth surface, there is no real bond and it can be readily peeled off and it will detach if electrical components having an appreciable mass are attached to the cured polymer ink to form more complex electrical circuits.

Although the roughness can be produced in a substrate after the substrate has been formed, it is much preferred to produce a substrate in which the required degree of surface roughness is moulded in at the time the substrate itself is formed. If, however, the roughness is subsequently produced in the substrate it can be achieved by means of sand-blasting, or by the use of a plasma etch for example. Thermo-setting plastics are commonly available in fine granular form which is converted into a desired shape by an injection moulding technique; that is to say, the granules are subject to heat and pressure so that they adopt the precise shape of the mould. In this case the mould has a surface region with the requisite degree of roughness. If desired, the whole of the surface of the mould may be rough, but in general, the roughness will be present only at those regions at which circuits are to be formed on the resulting substrate.

The roughness in the mould, which is usually a metal such as a steel or aluminium, can be formed by a spark erosion process in which a fine degree of control can be exercised over the degree of roughness. Alternatively, the roughness can be produced by the use of an acid etch or by sand blasting. Roughness is measured in terms of standard scales, the two most common being the VDI scale and the RA scale (roughnes average). Suitable degrees of roughness are 33 on the VDI scale and 4.5 on the RA scale, although a significant degree of latitude is possible, but the degree of bonding reduces appreciably at lower levels of roughness, and conversely as the roughness increases, the degree of circuit geometry resolution which it is possible to achieve becomes progressively worse. This is because it is difficult to provide very fine lines or gaps or the like in the cured polymer ink if the fluid ink is laid on to a coarse undulating surface. Nevertheless, there is an intermedate degree of roughness available centred on the figures given above which gives very good bonding and at the same time permits fine resolution of the order of 10 - 20 thousandths of an inch, i.e. 250-500 microns. As polymer inks are cured at relatively low temperatures, typically of the order of $150^{\circ}C$, the ink can be cured whilst in place on thermosetting plastic without causing degradation of the thermoplastic itself or the shape in which it has been formed.

According to a third aspect of this invention a method of making an electrical circuit includes the steps of forming a substrate having a roughened surface region of an electrically insulating plastics material; screen printing a fluid polymer electrical ink on to said roughened surface to produce a predetermined pattern; heating said substrate and the printed ink to cure the ink until it is set.

Preferably the requisite degree of roughness is moulded into a localised portion of the surface of the substrate at the time that the substrate itself is formed.

The invention is further described by way of example, with reference to the accompanying drawings, in which:

Figure 1 is a schematic view of an electrical circuit, and

Figure 2 is a more detailed sectional view thereof.

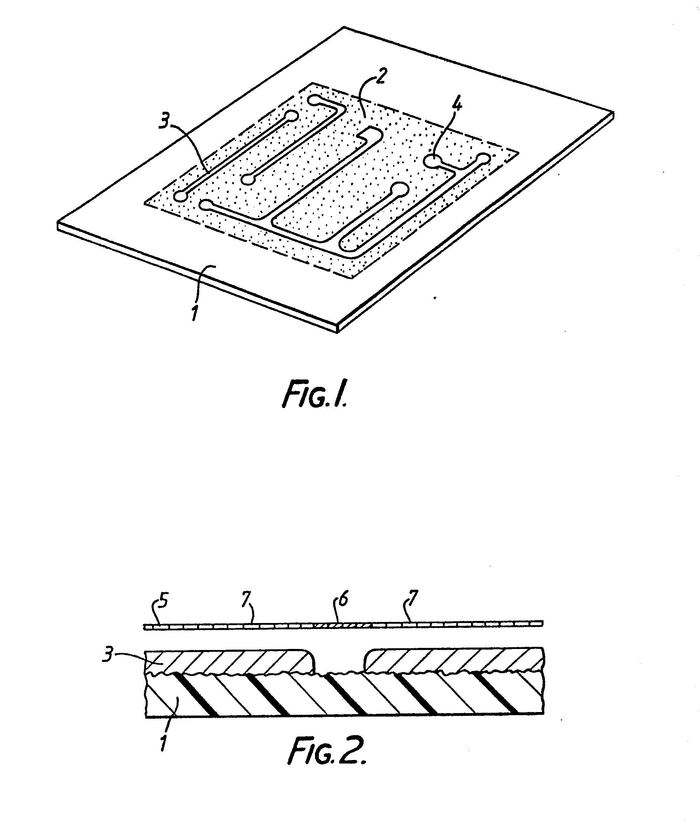

Referring to Figure 1, thre is shown therein a substrate 1 formed of a thermosetting moulded plastics material. Such a substrate is typically formed by the injection moulding of a plastics material such as polysulfone, which is usually supplied in the form of fine granules. The fine granules are injected under conditions of temperature and pressure into a preformed precision mould so that they adopt the exact shape of the mould. By this technique, moulded plastics articles can be generated which conform to a required size and shape with a high degree of precision. In this example the substrate is a thin sheet form having a generally smooth and shiny surface except for a central rectangular region 2 on its supper surface. This region 2 is of a roughened nature and is formed at the time the plastics substrate is moulded, as a corresponding region of the moulding tool is provided with the requisite degree of roughness. The rough surface of the moulding tool, which typically is of aluminium or steel, is formed by a spark erosion technique. Spark erosion techniques which give controlled degree of roughness are in themselves well known and the degree of roughness is generally measured by means of a gauge which registers on a particular scale. Alternatively, the roughness can be produced by the use of an acid etchant, or by a sand blasting process, but the degree of roughness may be more difficult to control. Once a suitable master tool has been formed having the correct surface finish it can be used to produce a very large number of individual and identical plastics mouldings. Care at this stage is required to ensure a consistant degree of roughness over the whole of the region 2. Suitable degrees of roughness are 33 on the VDI scale and 4.5 on the RA scale.

Alternatively, instead of using a moulding tool having the required degree of roughness extending over a specified area, it is possible to produce plastics substrates which are initially smooth over their entire surface. Subsequently, the degree of roughness required can be produced in each substrate individually by means of a sand-blasting technique or by plasma etching. These alternative techniques are not preferred since they result in a less reliable, fragile and predictable degree of surface roughness. Although the degree of surface roughness is not in itself critical to a single value, it is nevertheless important to keep it constant within close limits.

In Figure 1, circuit areas are formed within the roughened region 2 and these constitute portions of an electrical circuit to which electronic components can be subsequently attached. These circuit areas comprise conductive tracks 3 and pads 4 and are constituted by selectively formed regions of a suitable conductive polymer ink. The ink is applied to the roughened surface of the substrate using a conventional screen printing process. Referring to Figure 2, there is shown therein a sectional view through part of the electrical circuit and a printing screen 5 which is supported above the substrate 1 so as not to be taken in context therewith. This drawing illustrates part of the process in which the polymer ink is deposited selectively on the substrate 1. In conventional manner, the screen 5 consists of a very fine mesh which is coated with photosensitive emulsion which is then set at desired regions using a photolithographic technique to produce a mask, portions of which are opaque (and seal the interstices of the mesh) and portions of which are open (consisting of the open mesh). The ink is subsequently applied to the surface of the screen 5, and forced through open portions of the mesh by means of a squeegee or roller, the ink of course, passing only through those areas 7 of the mesh from which the emulsion has been removed. The remaining portion 6 of the emulsion therefore blanks off a portion of the substrate so that it does not receive ink. By suitable choice of the pitch of the mesh, the spacing of the mesh from the surface and the viscosity of the ink, a geometrical pattern can be formed in which the ink constitutes electrical tracks. The resolution of the geometry can be fairly fine, 250 to 500 micron resolution being readily achievable. Inks with different electrical properties, i.e. conductive or resistive, can be deposited having separate screens to form more complex circuits.

After the pattern of ink has been placed upon the substrate 1, the ink is cured by heating it to a temperature of about 150$^{o}$C for a specified time. It is found that after this period of curing, the ink adheres extremely well to the substrate. The conductive tracks so formed therefore form a very strong bond therewith from which they can be separated only with difficulty. This is in considerable contrast to the very weak bond which applies if the polymer ink is cured upon an initially smooth or shiny surface of a plastics material. The polymer ink may be chosen so as to have a very low resistivity so that it acts purely as a conductor, or alternatively, it may be chosen so as to exhibit a predetermined resistivity so that it is used to form resistors of specified values. Yet again the polymer ink may be chosen so as to behave primarily as an insulator with specified dielectric properties. In each case the particular electrical property is likely to be determined by the size and nature of particles carried within the ink and the mask which is used during the screen-printing process must be chosen with regard to the particle size of the ink. Suitable polymer inks are commercially available, e.g. from Electro-science Laboratories Inc., and can be chosen to exhbit the required electrical property - e.g. type 1109-S polymer ink is a conductive coating; series RS-150 polymer inks are suitable for resistive areas, and type 240-SB is a protective coating with a dielectric constant of about 6 to 8.

Subsequent to the formation of the electrical circuit of the kind shown in Figure 1, electronic components can be added if desired or required by the circuit function, by means of the technique described in our co-pending patent application (ref I/7033/MEDL).

CLAIMS

1.   An electrical circuit including a substrate of an electrical insulating material having a roughened surface region; said region carrying a low-temperature cured electrical ink of the kind which cures at a temperature of less than 200°C, the degree of roughness being such as to produce strong adhesion between the substrate and the cured ink.

2.   An electrical circuit including a substrate formed of an electrically insulating thermo-setting plastics material having a roughened surface region; said region carrying a low-temperature cured conductive polymer ink, the degree of roughness being such as to produce strong bonding resisting separation of the cured ink from the substrate.

3.   A method of making an electrical circuit including the steps of forming a substrate having a roughened surface region of an electrically insulating plastics material; screen printing a fluid polymer electrical ink on to said roughened surface to produce a predetermined pattern; heating said substrate and the printed ink to cure the ink until it is set.

4.   A method as claimed in claim 3 and wherein the requisite degree of roughness is moulded into a localised portion of the surface of the substrate at the time that the substrate itself is formed.

5.   A method as claimed in claim 3 or 4 and wherein the substrate is formed of a thermo-setting plastics material.

6. A method as claimed in claim 3, 4 or 5 and wherein the substrate is provided with a localised roughened region which does not extend over its entire surface.

7. A method as claimed in claim 3, 4, 5 or 6 and wherein the degree of roughness is in the order of 33 on the VDI scale and 4.5 on the RA scale.

8. A method as claimed in claim 4, 5, 6 or 7 and wherein a metal mould is utilised in which the roughness is formed by a spark erosion process.

9. An electrical circuit as claimed in claim 1 and wherein the degree of roughness is in the order of 33 on the VDI scale and 4.5 on the RA scale.

0199450

FIG.1.

FIG.2.